(19) **Europäisches Patentamt European Patent Office Office européen des brevets**

(11) **EP 4 364 177 B1**

(12) **EUROPEAN PATENT SPECIFICATION**

(45) Date of publication and mention of the grant of the patent:
**30.07.2025 Bulletin 2025/31**

(21) Application number: **21739773.6**

(22) Date of filing: **28.06.2021**

(51) International Patent Classification (IPC):
*H01J 27/26* (2006.01)    *B82Y 40/00* (2011.01)
*F03H 1/00* (2006.01)    *G03F 7/00* (2006.01)
*B05B 5/00* (2006.01)

(52) Cooperative Patent Classification (CPC):
**F03H 1/0037; B05B 5/0533; B05B 5/057; B05B 5/16; B05B 5/1608; G03F 7/0002; H01J 27/26;** B82Y 40/00

(86) International application number:
**PCT/IB2021/000394**

(87) International publication number:
**WO 2023/275579 (05.01.2023 Gazette 2023/01)**

(54) **EMITTER FOR ELECTROSPRAY GENERATORS AND METHOD FOR MANUFACTURING AN EMITTER FOR ELECTROSPRAY GENERATORS**

EMITTER FÜR ELEKTROSPRAYGENERATOREN UND VERFAHREN ZUR HERSTELLUNG EINES EMITTERS FÜR ELEKTROSPRAYGENERATOREN

ÉMETTEUR POUR GÉNÉRATEURS D'ÉLECTRONÉBULISATION ET PROCÉDÉ DE FABRICATION D'ÉMETTEUR POUR GÉNÉRATEURS D'ÉLECTRONÉBULISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.05.2024 Bulletin 2024/19**

(73) Proprietors:
- **Ienai Space, S.L.**
  **28919 Leganés Madrid (ES)**
- **Consejo Superior De Investigaciones Científicas**
  **28006 Madrid (ES)**
- **Fundació Institut Català de Nanociència i Nanotecnologia (ICN2)**
  **08193 Bellaterra, Cerdanyola del Vallès, Barcelona (ES)**
- **Institució Catalana de Recerca i Estudis Avançats**
  **08010 Barcelona (ES)**

(72) Inventors:
- **SEPULVEDA MARTÍNEZ, Borja**
  **08030 Barcelona (ES)**
- **NOGUÉS SANMIQUEL, Josep**
  **08174 Sant Cugat del Vallès, Barcelona (ES)**
- **GÜELL I GRAU, Pau**
  **17007 Girona (ES)**
- **PÉREZ GRANDE, Daniel**
  **28919 Leganés, Madrid (ES)**
- **WIJNEN, Mick**
  **28919 Leganés, Madrid (ES)**
- **CRUZ, Javier**
  **28919 Leganés, Madrid (ES)**
- **CORREYERO, Sara**
  **28919 Leganés, Madrid (ES)**

(74) Representative: **ABG Intellectual Property Law, S.L.**
  **Avenida de Burgos, 16D**
  **Edificio Euromor**
  **28036 Madrid (ES)**

(56) References cited:
**WO-A1-2014/193995**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- HILL FRANCES ANN ET AL: "High-Throughput Ionic Liquid Ion Sources Using Arrays of Microfabricated Electrospray Emitters With Integrated Extractor Grid and Carbon Nanotube Flow Control Structures", JOURNAL OF MICROELECTROMECHANICAL SYSTEMS, IEEE SERVICE CENTER, US, vol. 23, no. 5, 16 May 2014 (2014-05-16), pages 1237 - 1248, XP011560293, ISSN: 1057-7157, [retrieved on 20140929], DOI: 10.1109/JMEMS.2014.2320509
- MÁXIMO DULCE VIRIDIANA MELO ET AL: "Additively manufactured electrohydrodynamic ionic liquid pure-ion sources for nanosatellite propulsion", ADDITIVE MANUFACTURING, vol. 36, 21 November 2020 (2020-11-21), NL, pages 101719, XP055900417, ISSN: 2214-8604, DOI: 10.1016/j.addma.2020.101719
- LIANG XIAOGUANG ET AL: "Self-Assembly of Colloidal Spheres toward Fabrication of Hierarchical and Periodic Nanostructures for Technological Applications", ADVANCED MATERIALS TECHNOLOGIES, vol. 4, no. 3, 8 January 2019 (2019-01-08), DE, pages 1800541, XP055901826, ISSN: 2365-709X, Retrieved from the Internet <URL:https://api.wiley.com/onlinelibrary/tdm/v1/articles/10.1002%2Fadmt.201800541> DOI: 10.1002/admt.201800541

**Description**

## FIELD OF THE INVENTION

A first aspect of the present invention is related to a method for manufacturing an emitter for electrospray generators. The method comprising the steps of providing a substrate, presenting a plate and at least one protrusion, and then nanotexturizing the outer surface of the at least one protrusion with nanowires emerging from the low-relief surface in a direction perpendicular to the plate even in those nanowires located on the protrusion.

The present invention, according to a second aspect, also relates to the emitter resulting of the manufacturing method, the electrospray generator comprising the emitter according to the present invention and an electric space propulsion device comprising at least one electrospray generator thereof.

## PRIOR ART

Electrospraying, also known as electrodynamic spraying, is an electrostatic acceleration of conducting liquids which has been used to provide and create molecular or ionic flows in various technical fields such a biomedical applications, space propulsion applications, food area, pharmaceutical field, spectrometry applications, air purifier devices etc.

In order to apply this technique, a device, called electrospray emitter or generator, is usually employing a high voltage electric power for the purpose of dispersing an electrically conductive liquid such as a conductive liquid metal, colloid or ionic liquid. Theoretically, and ideally, the dispersed liquid is reaching an emitter tip and is sprayed in the shape of a cone.

However, particularly in the space propulsion field, said technique has been considered uninteresting to be implemented until the early 2000s since the progression of technology is leading to smaller satellites classes requiring low power propulsion systems.

An electrospray device generally includes an emitter and a counter-electrode. Both of these elements provide a liquid the ability to undergo atomization and result into nano or micro droplets, pure ion emission or a mix of both. Said liquid is mostly defined by its density, viscosity, its surface tension, its relative permittivity and its electrical conductivity.

When an electric field is applied to the liquid/solid interface of a conductive liquid, charge migrates to the interface where the conductivity is discontinuous, causing the liquid to move. For a sufficiently conductive liquid, the tangential to the liquid surface electric field will be zero and, in steady state, the remaining normal component of the electric field will balance the local surface tension. The normal component of the electric field shows an expression depending on $r^{-1/2}$ among other parameters being singular for $r \rightarrow 0$, with $r$ the radius of the corresponding cone-like structure generated through charge migration.

In electrospray configurations, the use of tip-ended structures with radii as small as possible is sought in order to concentrate the electric field lines.

When a volume of electrical conductive liquid is exposed to an electric field, the shape of the liquid starts to deform from the shape caused by surface tension alone. As the voltage is increased, the effect of the electric field becomes more prominent. As this effect of the electric field begins to exert a similar magnitude of force on the droplet as the surface tension does, a cone shape begins to form with convex sides and a rounded tip. This results in approaching the shape of a cone named "Taylor cone". When a certain threshold voltage has been reached, the slightly rounded tip inverts and emits a jet of liquid which is called a cone-jet. This cone-jet emission is the beginning of the electrospraying process in which ions may be transferred to the gas phase. It is generally found that, in order to achieve a stable cone-jet, a voltage, slightly higher than threshold, must be used. As the voltage is increased even more, other modes of droplet disintegration are found.

In this context, the non-dimensional flow parameter

$$\zeta = \sqrt{\frac{\rho K Q}{\gamma \kappa \varepsilon_0}}$$

is a very relevant parameter governing the flow wherein $\rho$ is the density of the fluid, $\kappa$ is the dielectric constant of the liquid, $K$ is the conductivity of the liquid, $Q$ is the volumetric flow rate, $\gamma$ is the liquid surface tension and $\varepsilon_0$ the permittivity of free space. This parameter is the main parameter of the current emitted from the tip of a Taylor cone but breaks down around $\zeta \approx$ 1 where droplet emission stops and a pure ionic regime begins. Said regime is reached if the electric field is high enough to achieve ion evaporation. Therefore, the $\zeta$ parameter must be lower than 1 for an electrospray device operating in the ionic regime.

Depending on the fluidic and electric field conditions, emission conditions can be in the form of jet, droplet, ion or a mixture of droplet and ionic emission. In the context of the invention, it is sought that the emission be pure ionic. Near the cone tip, the field can be strong enough to liberate ions directly from the surface, which is called field evaporation.

The electric field at the tip of the emitters is a function of the applied electric field, the emitter-extractor geometry and actual shape of the liquid meniscus and may be represented by $f \cdot V$ which is the product of the normalized angular emission profile and the applied voltage. The lowest voltage, which allows for field evaporation, is known as the critical voltage.

The tip radius is that of the meniscus, which deforms under the influence of the electric field and at the same time determines the electric field. The difficulty is in determining this radius which is not a parameter set by the manufacturing process. Nonetheless, emitter-extractor geometry is very relevant on the electric field at the tip since it may show specific shapes intended for concentrating the electric field.

In pure ionic electrosprays the volumetric flow of the liquid feeding the emitter must compensate the electrostatic evaporation; while some sort of flow restriction is also typically needed in order to ensure the pure ionic regime.

According to the prior art, several types of emitters are known:

### Capillary type

A capillary type emitter is based on the use of a capillary conduit through which the liquid is fed. The end of the capillary ends in a pointed microstructure that causes the concentration of the electric field in the meniscus of the fluid exiting through the capillary.

The main technological challenges for capillary emitter are:

- A minimum pressure driving the flow is required to drive a volumetric flow to the electrospray emitters otherwise the emissions stops or becomes irregular for lower pressures.
- The narrow fluidic channels present in capillary electrosprays are prone to clogging from impurities in the liquid or debris generated in the device throughout its operation.
- Capillary electrosprays present a low fluidic impedance typically leading to the droplet or mixed regimes, but generally incapable of achieving the ionic regime.

### Porous type

Porous type emitters were introduced as an alternative to capillary types in an attempt to overcome some of the limitations of these devices: mainly the reliance on pressure feeding which could be replaced by passive feeding in porous mediums. Clogging issues may also be reduced since multiple paths to the emitter tips now exist within the porous medium.

The main technological challenges for porous emitter are:

- High fluidic impedance is required in order to achieve the pure ionic regime and this requires small pore sizes which are conflicting with the reduction of clogging proposed as one of the advantages of the technology.
- The length scale of the Taylor cone in emission zones depends on the pore size. This entails that for small pore radius, which is required for high fluidic impedance to achieve the pure ionic regime, emissions zones can exist in multiple locations close to the microstructure tip, where the electric field is concentrated. This can lead to larger dispersion angles than other emitters and substantially lower angular dispersion efficiency.
- It has been observed that a capacitive double layer exists in the boundary between the emitter and the ionic liquid. For lengthy emission times or high currents, the electrochemical window limit may be surpassed, leading to chemical reactions between the ionic liquid and the material, which have been shown to etch and roughen the emitter tips; causing degradation of the emission characteristics over time.

### Externally wetted type

An alternative solution to capillary electrosprays is externally wetted type emitters wherein the surface of the emitter is coated with a wicking material for liquid transport to the emitter tips through capillary forces. This type of emitters can have the required hydraulic impedance to achieve pure ionic regime. For instance, a surface coating made of black silicon is known to work, but the coating's morphology, particularly the surface distribution and aspect ratio, are not controllable through the typically applied methods; thus, it does not allow to engineer the hydraulic impedance by tuning the nanostructures height or separation distance. Furthermore, coatings may mechanically degrade over time under the stresses due to the operation of the device.

It has been determined that, in order to achieve high throughput externally wetted electrosprays operating at limited voltages, the design of the emitter must be oriented toward reducing both the onset voltage and the hydraulic impedance, as long as values for the latter are sufficiently high to maintain the ionic regime. Since the hydraulic impedance presents an "optimum" value which maximizes the extracted current while allowing for ion emission, the main problem that arises is to establish a surface texture that allows control over the hydraulic impedance.

None of the emitter types described above can solve this problem satisfactorily. In contrast, the present invention sets forth a method of manufacturing an externally wetted type nanotexturized emitter that allows for accurate determination of hydraulic impedance in a passive liquid feeding while ensuring high mechanical strength. Additionally, it has been proven that the device, thus fabricated, overcomes each of the drawbacks described in the prior art.

Document WO2014/193995A1 discloses electrospraying systems and associated methods.

Document from HILL FRANCES ANN ET AL published in journal of microelectromechanical systems, IEEE SERVICE CENTER, us, vol. 23, no. 5, 16 May 2014, discloses "HIGH-THROUGHPUT IONIC LIQUID ION SOURCES USING ARRAYS OF MICROFABRICATED ELECTROSPRAY EMITTERS WITH INTEGRATED EXTRACTOR GRID AND CARBON NANOTUBE FLOW CONTROL STRUCTURES".

## DESCRIPTION OF THE INVENTION

The present invention provides a method for manufacturing an emitter for electrospray generators according to claim 1, an emitter for electrospray generators according to claim 11, an electrospray generator according to claim 15 and an electric space propulsion device according to the fourth inventive aspect mentioned below. Advantageous embodiments are defined in the dependent claims.

*According to a first inventive aspect, the invention provides a method for manufacturing an emitter for electrospray generators, the method comprising the steps:*

- *providing a substrate, the substrate comprising:*

    *a plate;*
    *at least one protrusion with a base located on a first side of the plate; the at least one protrusion ended in a tip;*

- *nanotexturizing the outer surface of the at least one protrusion, characterized in that nanotexturizing the outer surface process comprises the steps:*

    *a) covering the surface with a suspension comprising a carrier fluid and particles;*
    *b) removing the carrier fluid from the suspension leaving behind a mask comprising a plurality of the particles partially protecting the surface;*
    *c) carrying out, in a direction perpendicular to the plate, a main etching process for removing a predetermined depth of the substrate not being protected by the particles, wherein the main etching process is configured for showing a low-relief etched surface with nanowires emerging from the low-relief surface in a direction perpendicular to the plate even in those nanowires located on the protrusion.*

The present invention provides a method for manufacturing an emitter for electrospray generators. Said method comprises a first step of providing a substrate. The substrate comprises a plate which presents at least one protrusion located on a first side of the plate. The contact line between the at least one protrusion and the plate defines the base of the at least one protrusion.

The at least one protrusion ends in a tip in order to ease the concentration of the electrical field causing the generation of ions or charged droplets emission. Additionally, the concentration of the electrical field is strong enough to liberate ions of a conductive liquid or colloid directly from the surface of the tip.

The electric field at the tip of the emitter is a function of the applied electric field, the taper angle and the emitter extractor geometry, such as the height of the emitter, the tip radius etc. Said taper angle is defined being the angle between the perpendicular from the plate to the tip of the protrusion and a side of the protrusion.

Advantageously, decreasing the tip radius, increasing either or both the taper angle and the cone height all provide an increase of the electric field at the tip of the emitter and a reduction of the onset voltage necessary for functioning.

Then, the present invention provides a method for manufacturing an emitter for electrospray generators presenting a second step of nanotexturizing the outer surface of the at least one protrusion.

By nanotexturizing it is understood a surface being covered with nano size structures.

The process of nanotexturizing the outer surface of the at least one protrusion comprises a first step of covering the surface with a suspension comprising a carrier fluid and particles. This first step of the process of nanotexturizing the outer surface of the at least one protrusion tends to cover the whole plate homogeneously in order to provide optimal basis for the following steps of the process.

The carrier fluid of the suspension covering the at least one protrusion of the plate is a solvent in which the particles do not dissolve, such as water, ethanol or any solvent that is polar and does not affect the particles transported by the suspension. According to an embodiment, the suspension is a colloidal suspension allowing a very homogeneous suspension of the colloidal particles.

Both the parameters of concentration of particles in the suspension and time of incubation are susceptible to be modified in order to get the optimal features and characteristics of the emitter in its specific operative conditions.

Then, the process of nanotexturizing the outer surface of the at least one protrusion comprises a second step of removing the carrier fluid from the suspension leaving behind a mask comprising a plurality of particles partially protecting the first side of the plate.

The second step of the process allows a homogeneous repartition of the suspension over the first side of the plate in order to cover its surface with a controlled amount of particles once the excess of suspension has been removed.

Finally, the process of nanotexturizing the outer surface of the at least one protrusion comprises a third step of carrying out a main etching process for removing a predetermined depth of substrate not being protected by the mask of particles previously deposited, generating the nanostructures

Said coating of nanostructures, presents relevant parameters such as the packing density and diameter of the nanostructures. Both parameters provide the ability to achieve variation of the emitter operative regimes.

The third step of the process of nanotexturizing the outer surface of the at least one protrusion is to perform a main etching process which removes a predetermined depth of substrate not protected by the particles previously applied in the first and second steps of the process. Said etching process is responsible for the formation of nanowires on the first side of the plate and the protrusion of the substrate. All the nanowires being oriented perpendicular to the substrate since the etching process is configured to etch in said direction.

In a preferred embodiment, the main etching is performed with Si.

The combination of the previously mentioned steps, which is combining a suspension of particles, preferably a colloidal suspension, and a deep reactive ion etching, results in a precise control over the nanotexturizing process of the substrate and over the geometry of the nanostructures, more particularly the formed nanowires.

The plurality of characteristics and features such as the density of nanowires, their orientation, their diameter and their aspect ratio are also precisely controlled thanks to the sequence of steps for nanotexturizing the outer surface of the at least one protrusion and the first side of the plate. The control over key parameters like density and aspect ratio is key to minimize the necessary onset voltage and control the hydraulic resistance of the substrate which allow maximizing the current keeping a pure ionic regime.

Advantageously, by controlling all parameters during the process, the resulting nanostructures are mechanically robust. As the nanowires can be made relatively thick, preferably in a range of hundreds of nm, and are carved on the substrate and thus a non-separate part of it, they result in being firmly attached to the substrate and, consequently, cannot be ejected during the operative mode of the emitter under high electric field.

Additionally, the mechanical strength of the nanostructures also prevents the nanowire buckling that can be generated by the high capillary force of the ionic liquid during the wetting and flow processes previously mentioned.

*In a particular embodiment, at least one region connected with the at least one protrusion of the first side of the plate is nanotexturized.*

At least one connected region of the first side of the plate presents at least one protrusion which presents at least one region nanotexturized and thus the presence of nanostructures, so called nanowires due to the resulting shape of the etched surface, covering at least one protrusion of the substrate.

In a preferred embodiment, the whole protrusion and first side of the plate is nanotexturized and thus present a plurality of nanowires on its surface.

*In a particular embodiment, the suspension is a colloidal suspension comprising colloidal particles.*

In a preferred embodiment, the suspension is a colloidal suspension comprising colloidal particles in a solvent as a carrier. Additionally, the suspension covers the at least one protrusion in order to provide control over the hydraulic resistance of the nanotexturized region. According to the previous embodiment, the suspension also covers at least one connected region of the substrate in order to provide a further control over the hydraulic resistance of the nanotexturized region feeding the tip of the protrusion.

In a preferred embodiment, the whole substrate is evenly covered by the suspension and, thus, is completely covered with colloidal particles.

*In a particular embodiment, the particles are nano/micro particles.*

Advantageously, the particles are nano or micro particles and can be implemented either in a nanostructure as well as a microstructure. In particular, an externally wetted electrosprays is based on microstructures, such as emitters, implemented for providing nanostructures which allow wicking of the liquid toward the microstructure tip by means of capillary forces and also generate hydraulic resistance necessary for flow restriction of the substrate, therefore leading to the ionic regime.

*In a particular embodiment, nanotexturizing the outer surface process further comprises:*

- *before step a), covering the surface to be nanotexturized with a first covering layer; and,*
- *after step b) and before step c), carrying out a preliminary etching process, respectively to the main etching process from step c), for removing the parts of the first covering layer not being protected by the mask of particles, resulting in a transference of the suspension mask to the first covering layer.*

The main process of nanotexturizing the outer surface process can also present an additional step prior to the first step which is covering the surface to be nanotexturized with a first covering layer applied over the substrate in order to ease the following main etching step.

The process of nanotexturizing the outer surface process can also present another additional step between its second and third main steps which is carrying out a preliminary etching process, respectively to the main etching process of the third main step, in order to remove parts of the first covering layer which are not being protected by the mask of particles applied in the second step of the above mentioned process. In a result, the suspension mask is transferred to the first covering layer.

Advantageously, the implementation of this additional step of carrying out a preliminary etching process increases the selectivity of the mask against the substrate and provides the ability to use the patterned first covering layer as a mask during the main etching, allowing for a longer main etching process and not damaging the mask as much as if it was done with only particles as mask.

*In a particular embodiment, the first covering layer is a material among the following: Au, Al, Cr, Ti, Ni, Pt, Co, Fe, W, Ta, Cu, Zn, any of the possible alloys among them, $SiO_x$, $Si_xN_y$, $Al_2O_3$, any metal oxide or any combination of them.*

In a preferred embodiment, the first covering layer material is Au which provides an easier etching while combined with a particular type of plasma such as Ar in a reactive ion etching.

Additionally, in the same preferred embodiment, the Au layer is treated in oxygen plasma to provide a negatively charged surface and enable the electrostatic self-assembly of positively charged particles carried in the suspension. This step also applies to any covering layer.

In particular, a water suspension comprising beads is used to produce self-assembled monolayer of well separated particles on the charged Au surface of the substrate.

Advantageously, the surface density of the deposited particles, or so called colloids, can be adapted by controlling the surface charge of the Au (or beads), as well as the particles concentration in the suspension and its incubation time since the concentration of particles per unit area depends on the number of particles migrated to the surface.

Also in the same preferred embodiment, the substrate is rinsed in order to remove the remaining floating colloids after applying the suspension and dried using critical point drying technique in order to avoid the capillary forces upon drying which can modify the correct distribution of colloids on the surface.

Then, the monolayer of particles is used as mask in the reactive ion etching step in order to form an array of Au discs, or any other material if used, on the substrate. Said Au discs act subsequently as a mask in the main etching step in order to form the array of nanowires on the substrate. Each Au disc generates a nanowire since the material surrounding the disc is removed downward. The resulting surface comprising nanowires may show the disc of the mask on the top of the nanowire.

Advantageously, by performing the previous sequence of steps, the formed array of nanowires is perpendicular to the first side of the plate of the substrate.

Also, by performing the previous sequence of steps with control allows to tune the hydraulic resistance of the coating. For instance, having a larger aspect ratio enables a reduction of the hydraulic resistance, thereby achieving devices with higher current throughput. Said higher current throughput devices can also be achieved either using thinner nanowires providing higher permeability and lower resistance or a lower surface density of nanowires.

In addition, implementing the previously described techniques allows a cost-effective and large-scale uniform etching, thereby forming a nanowires forest of controlled densities.

Furthermore, a lower density of nanowires leads to a larger separation between individual nanowires. That is, according to some preliminary experiments, it increases the effective length scale which could allow to initiate the ionic emission at a lower onset voltage.

*In a particular embodiment, the first covering layer is deposited by physical vapor deposition.*

By performing the deposition of the first covering layer thanks to a physical vapor deposition process, the following preliminary etching, reactive ion etching, is performed more easily and increase the performance of the upcoming main etching. The time spent during the deposition allows controlling the thickness of the resulting first covering layer.

*In a particular embodiment, the colloidal suspension comprises one of the following particles: polymer, preferably latex or polymethylmethacrylate (PMMA); Si, SiO2, ZnO, Zn, FexOy, Al2O3, Au, Pt.*

In an embodiment, selected particles of the colloidal suspension are resistant to the Si etching process such as SiO2, Au or Pt.

*In a particular embodiment, the suspension composition comprises charged particles and in order to ease the attachment and distribution of the particles on the first covering layer.*

By using charged particles, said particles attach and are evenly distributed over the first covering layer. In that preferred embodiment, the particles are selected in function of its charge in order to enhance the performance of the covering step of the process.

Having control over the charge allows to control the number of particles migrating to the first covering layer and therefore the density of the resulting forest of nanowires.

*In a particular embodiment, the particles are homogeneously distributed on the first covering layer.*

By applying and setting an electrical voltage having the opposite charge of the particles comprised in the suspension provide a homogeneous distribution of the particles over the first covering layer which eases the following main etching step of the process. The use of a colloidal suspension allows a uniform distribution of particles in the suspension helping to a more uniform distribution of particles in the first covering layer.

*In a particular embodiment, the first covering layer, the substrate or both has/have a surface charge by means of:*

- a pre-surface chemical or plasma treatment;
- *providing an electrical voltage;*
- *or both.*

In a preferred embodiment, the substrate and the projected charged particles perform a self-assembly using the inherent superficial charge of the substrate.

The substrate, the first covering layer, or both, already has/have a surface charge generated due to the material discontinuity. A further embodiment comprises a step for treating the surface with a pre-surface chemical or plasma treatment projecting charged particles. According to another embodiment, the first covering layer, the substrate or both is/are set to an electrical voltage with an electrical charge opposite to the electrical charge of the charged particles having a higher control over the charged particles migrating to the surface.

In another preferred embodiment, a pre-surface chemical is applied, such as a coating with monolayers of polyelectrolyte monolayers, or plasma treatment, such as oxygen plasma, thus, projected charged particles are spread before setting the first covering layer.

In that preferred embodiment, the selected particles are superficially charged with the opposite charge compared to the superficial charge of the substrate.

*In a particular embodiment, the preliminary etching step is based on the projection of plasma, preferably plasma of Ar, in a direction perpendicular to the plate.*

The projection of plasma, preferably plasma of Ar, bombards the surface of the substrate and mechanically pulls out atoms of said surface.

In a preferred embodiment, the flow of projected Ar plasma is directionally spread, in particular perpendicularly, in order to reach a kinetic energy capable of pulling out said atoms. As a result, this process forms nano-discs on the substrate surface and said nano-discs diameter is the diameter of the nanowire that is to be formed after performing the main etching.

In the same preferred embodiment, the perpendicular projection of plasma results in the apparition of nanowires perpendicular to the surface of the plate. The nanowires generated on the protrusion keep the same orientation than the orientation of those nanowires located on the main surface of the substrate causing a good interface between the plate surface and the protrusion surface allowing improved feeding conditions in operative manner since the fluid interacts with a continuously nanotexturized surface.

*In a particular embodiment, the main etching step is an anisotropic etching process of the substrate.*

Advantageously, and in the preferred embodiment of the main etching being performed with Si, the anisotropic etching process helps forming substantially vertical nanowires.

*In a particular embodiment, the main etching step is performed with a combination of fluorinated gases.*

*In a particular embodiment, the main etching step comprises at least one step of inducing plasma performed simultaneously or in any order with the following gases:*

- *$SF_6$;*
- *$C_4F_8$;*
- *a combination of both gases.*

In a preferred embodiment, the plasma is induced with the previously cited fluorinated gases, firstly with $SF_6$, then with $C_4F_8$ or a unique combination of both gases, directed perpendicularly towards the substrate while setting an electric voltage.

Said sequence of combination of gases provides the ability to perform an anisotropic etching as main etching step of the process and eases the ability to obtain better aspect ratio of the geometry features of the nanowires.

*In a particular embodiment, the diameters of the particles are in the range [50nm-5000nm], most preferably in the range [100nm-3000nm], most preferably in the range [200nm-1000nm].*

The diameter of the particles establishes the diameter of the formed nanowires and consequently influences the size and surface density of said formed nanowires.

*In a particular embodiment, the surface density of the particles deposited on the first covering layer or substrate are in the range [0.001-50] particles per square micron, most preferably in the range [0.05-10] particles per square micron.*

The surface density of the particles deposited on the first covering layer, if performed, or on the substrate depends on the particle concentration contained in the suspension applied during the first step of the process but also depends on the time of incubation. The resulting surface density of the particles is also the resulting density of nanowires.

*In a particular embodiment, the suspension comprises a polar solvent.*

In particular, the selected polar solvent comprised in the suspension does not dissolve the particles.

Also, advantageously, the selected polar solvent provides stable dispersion of charged particles which is required for ensuring the electrostatic self-assembly.

*A second aspect of the invention is an emitter for electrospray generators, the emitter being a substrate and the substrate comprising:*

- *a plate;*
- *at least one protrusion with a base located on a first side of the plate; the at least one protrusion ended in a tip;*

*wherein the outer surface of the at least one protrusion is nanotexturized according to any embodiment of the first inventive aspect; and,*
*wherein the nanotexturized surface shows a low-relief etched surface with nanowires emerging from the low-relief surface in a direction perpendicular to the plate even in those nanowires located on the protrusion.*

The emitter for electrospray generators comprises a substrate which presents a plate, at least one protrusion with a base located on a first side of the plate wherein the outer surface of the at least one protrusion is nanotexturized and said nanotexturized surface shows a low-relief etched surface comprising nanowires emerging from said low-relief surface.

Since the ends of the nanowires correspond to the original surface that has been carved by the etching process, the textured surface also shows a smooth configuration with preset dimensions. This is not the case if the nanowires are elements added to a surface where there is no control over their orientation and no control over the top surface bounding the textured region.

In a preferred embodiment, the plurality of nanowires are perpendicular to the plate even in those nanowires located on the protrusion being the results of the perpendicular chemical etching performed during the nanotexturizing process. The orientation is independent of the inclination of the surface on which the nanowires are placed, thus ensuring uniform nanotexturized surface.

*In a particular embodiment, the substrate comprises at least one liquid source.*

In a preferred embodiment, the substrate comprises at least one liquid source used as an ionic liquid propellant. Advantageously, comprising the at least one liquid source inside the substrate provides a fluidic communication between the nanotexturized surface of the plate and/or the protrusion of the emitter allowing a continuous feeding of the liquid.

*In a particular embodiment, each protrusion has at least one liquid source located at the protrusion or at a connected region of the substrate adapted to feed the base of the protrusion.*

According to this embodiment, each protrusion presents at least one liquid source located at the protrusion or at a connected region of the substrate adapted to feed the base of the protrusion in order to maintain fluidic communication between all parts of the whole substrate of the emitter and therefore the emitter is in operative manner without a time limitation.

*In a particular embodiment, the connected region of the substrate is further nanotexturized.*

According to this embodiment, when the liquid source is in the connected region of the substrate and the substrate is in contact or adjacent to the protrusion, the liquid provided by the source is fluidically connected with the tip of the protrusion. The capillary forces allow the wetting process of the nanotexturized surface providing a continuous communication.

*In a particular embodiment, the liquid source is a perforation fluidically connecting the first side and the opposite side of the plate.*

In a preferred embodiment, the liquid propellant comes from a liquid source reservoir and passes through the plate of the substrate thanks to at least one perforation and thus, provides the fluidic communication between the first side and the opposite side of the plate.

*In a particular embodiment, the hydraulic resistance $R_H$ is ranging in [$10^{15}$-$10^{20}$ Pa.s.m$^{-3}$], more preferably in [$10^{15}$- $10^{18}$ Pa.s.m$^{-3}$], even more preferably in [$10^{16}$- $10^{18}$ Pa.s.m$^{-3}$], $R_H$ being calculated as:*

$$R_H = -\frac{\mu \ln(r^*/H)}{2\pi Kh \sin \alpha}$$

*wherein the permeability, K, is calculated as:*

$$\frac{K}{d^2} = 0.16 \frac{\left[\frac{\pi}{2\sqrt{3}\psi} - 3\sqrt{\frac{\pi}{2\sqrt{3}\psi}} + 3 - \sqrt{\frac{2\sqrt{3}\psi}{\pi}}\right]}{\sqrt{1-\psi}}$$

*and wherein the volume fraction $\psi$ is calculated as:*

$$\psi = N \cdot \frac{\pi d^2}{4}$$

*wherein H is the hight of the protrusion, h is the height of the nanotexturized surface, r\* is the radius of the tip of the protrusion, $\alpha$ the semi-angle of the protrusion according to a sectional view, $\mu$ is the dynamic viscosity, d the diameter of the wires of the nanotexturized surface and $\psi$ is the volume fraction of wires of the nanotexturized surface and N is the density of wires.*

Adapting the density of nanowires on the surface provides an efficient control of the hydraulic resistance.

Additionally, reducing the density of nanowires increases the hydraulic permeability and reduces de hydraulic resistance in the particular case of an externally wetted emitters.

At the same time, the reduction of nanowires density leads to an increase of the average distance in between nanowires which also present consequences such as the reduction of necessary onset voltage and still ensure the ionic regime.

*In a particular embodiment,* the permeability $K$ is in the range $[10^{-16}, 10^{-11} \, m^2]$, more preferably $[10^{-14}, 10^{-11} \, m^2]$, even more preferably $[10^{-13}, 10^{-11} \, m^2]$, wherein the permeability, K, is calculated as:

$$\frac{K}{d^2} = 0.16 \frac{\left[\frac{\pi}{2\sqrt{3}\psi} - 3\sqrt{\frac{\pi}{2\sqrt{3}\psi}} + 3 - \sqrt{\frac{2\sqrt{3}\psi}{\pi}}\right]}{\sqrt{1-\psi}}$$

*and wherein the volume fraction $\psi$ is calculated as:*

$$\psi = N \cdot \frac{\pi d^2}{4}$$

*wherein d is the diameter of the wires of the nanotexturized surface and $\psi$ is the volume fraction of wires of the nanotexturized surface and N is the density of wires.*

*In a particular embodiment, the volume fraction $\psi$ is calculated as:*

$$\psi = N \cdot \frac{\pi d^2}{4}$$

*wherein d is the diameter of the wires of the nanotexturized surface and N is the density of wires.*

*In a particular embodiment of the method of manufacturing an emitter and the emitter being manufactured wherein the substrate of the emitter is a semiconductor.*

Advantageously, the method for manufacturing an emitter as well as the emitter present a substrate being a semiconductor in order to ease the steps of the process where the charge of the employed particles is influencing the performance of depositing said particles on the substrate and some preliminary experiments show that this feature lower the necessary onset voltage while in operative condition.

*In a particular embodiment of the method of manufacturing an emitter and the emitter being manufactured wherein the substrate is Si.*

By presenting a Si substrate, the method of manufacturing an emitter as well as the emitter, in the particular embodiment of a Si etching process to form Si nanowires, provides a more mechanically robust substrate in that particular case of an externally wetted emitter.

*In a particular embodiment of the method of manufacturing an emitter and the emitter being manufactured wherein the substrate is glass.*

*In a particular embodiment of the method of manufacturing an emitter and the emitter being manufactured wherein the at least one protrusion is cone shaped, pyramid shaped, spiral shaped, edge shaped, pointy shaped or needle shaped.*

By providing at least one protrusion having a cone shape, pyramid shape, spiral shape pointy shape or needle shaped, the method of manufacturing an emitter, when the emitter presents said at least one protrusion shape, provides the advantage of concentrating a high electric field in order to maximize the pure ionic regime during operative conditions of the emitter.

Once the electric field has reached a sufficient intensity either because the form factor concentrates the electric field lines or because of the applied voltage, the conditions for the emission, coupled with the correct hydraulic resistance offered to the fluid and its correct temperature, ensures reaching the ionic regime. According to the invention, the structure of nanowires obtained with the manufacturing method and the emitter thus obtained ensure that ionic emission conditions are achieved more easily.

*In a particular embodiment of the method of manufacturing an emitter and the emitter being manufactured wherein the tip of the emitter is a structure adapted for electric field concentration.*

*A third aspect of the invention is an electrospray generator comprising:*

- *an emitter according to any embodiment of the second inventive aspect;*
- *an electrode facing the side of the plate of the emitter with the at least one protrusion and separated from said at least one protrusion;*
- *the electrode comprising at least an opening for letting generated ions or drops to pass through;*
- *an electrical power supply for setting voltage between the substrate and the electrode;*
- *a liquid source fluidically communicated with the nanotexturized surface of the plate for feeding liquid to said surface.*

The electrospray generator comprises an emitter with at least one protrusion and/or at least one connected region nanotexturized, an electrode having at least an opening for letting the generated ions or drops passing through and an electrical power supply for setting voltage between the substrate and the electrode generating the electrical field.

In a preferred embodiment, the electrode is a plate parallel to the plate of the substrate of the emitter, located on top of said emitter and separated from the protrusions of the same emitter. The electrode is covered with holes in order to let ions and drops pass through once the electrospray generator enters in operative mode.

In another preferred embodiment, the emitter of the electrospray generator presents at least one protrusion of its substrate nanotexturized following the step of the process of the first aspect of the present invention.

Therefore, by performing an etching process for nanotexturizing, it results in preventing the adhesion issues of the nanowires and thereby decreasing the long term degradation of the electrospray generator.

*A fourth aspect of the invention is an electric space propulsion device comprising at least one electrospray generator according to any embodiment of the third inventive aspect.*

The increase of the mechanical resistance of the substrate comprised in the at least one electrospray of an electric space propulsion device, and the mechanical resistance of the nanowires, both produced by both the main etching process and additional preliminary etching process, increase the durability and survivability and reduces the potential degradation caused by launch environment where the mechanical vibrations are quite high.

## DESCRIPTION OF THE DRAWINGS

These and other features and advantages of the invention will be seen more clearly from the following detailed description of a preferred embodiment provided only by way of illustrative and non-limiting example in reference to the attached drawings.

Figure 1 This figure shows a schematic representation of an embodiment of an electrospray generator according to the present invention.

Figure 2 This figure shows a schematic representation of an embodiment of an electrospray generator according to the present invention.

Figure 3 This figure shows a schematic representation of an embodiment of the structure of an emitter with a plurality of protrusions of an electrospray generator according to the present invention.

Figure 4A-F These figures show a schematic representation of an embodiment of the steps of the method for manufacturing an emitter for electrospray generators according to the present invention.

Figure 5 This figure shows an image from a scanning electron microscope of an embodiment of an electrospray generator according to an embodiment of the present invention.

Figure 6 This figure shows an image from a scanning electron microscope of an embodiment of a region of an electrospray generator presenting a plurality of nanowires according to an embodiment of the present invention.

Figure 7 This figure shows an image from a scanning electron microscope of an embodiment of a region of an electrospray generator presenting a plurality of nanowires according to an embodiment of the present.

## DETAILED DESCRIPTION OF THE INVENTION

As will be appreciated by one skilled in the art, aspects of the present invention may be embodied as method for manufacturing an emitter for electrospray generators, an emitter for electrospray generators, an electrospray generator or an electric space propulsion device comprising at least one electrospray generator.

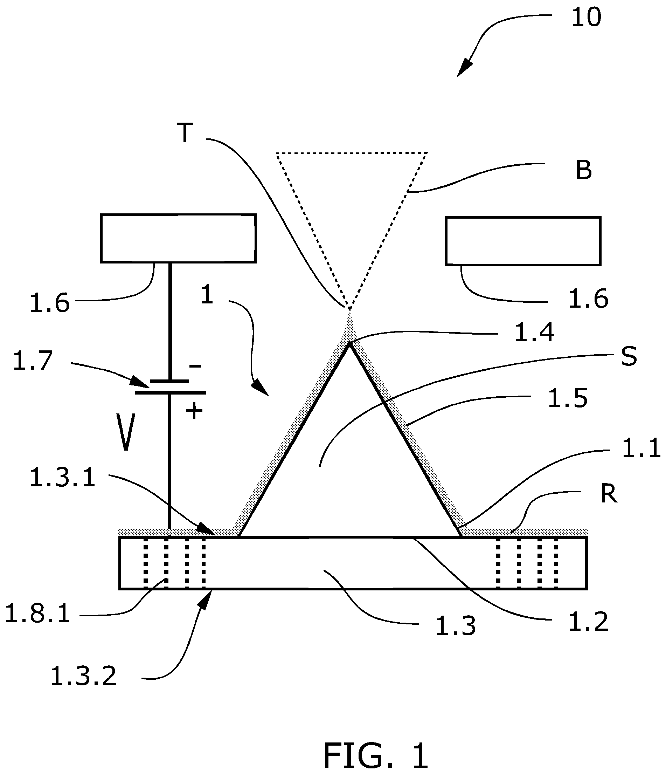

Figure 1 depicts a schematic representation of an emitter (1) for an electrospray generator (10) comprising an emitter (1) which is formed by a protrusion (1.1) located on a first side of a plate (1.3). On one hand, the protrusion (1.1) presents a base (1.2) located on a first side (1.3.1) of the plate (1.3) and, on the other hand, the same protrusion (1.1) ends in a tip (1.4)

The emitter (1) is made of a substrate (S) which is preferably a semiconductor. More preferably, the substrate (S) of the emitter (1) is Si or glass. Even more preferably, the substrate (S) of the emitter (1) is Si.

Moreover, in the particular embodiment shown in Figure 1, the protrusion (1.1) of the emitter (1) is cone shaped and ends in a tip (1.4) in order to provide a structure adapted for electric field concentration. In other particular embodiments, the protrusion (1.1) of the emitter (1) can present a conical shape, pyramid shape, a needle shape, a spiral shape, an edge shape, a pointy shape or in any commonly known shape which provide a structure adapted for electric field concentration.

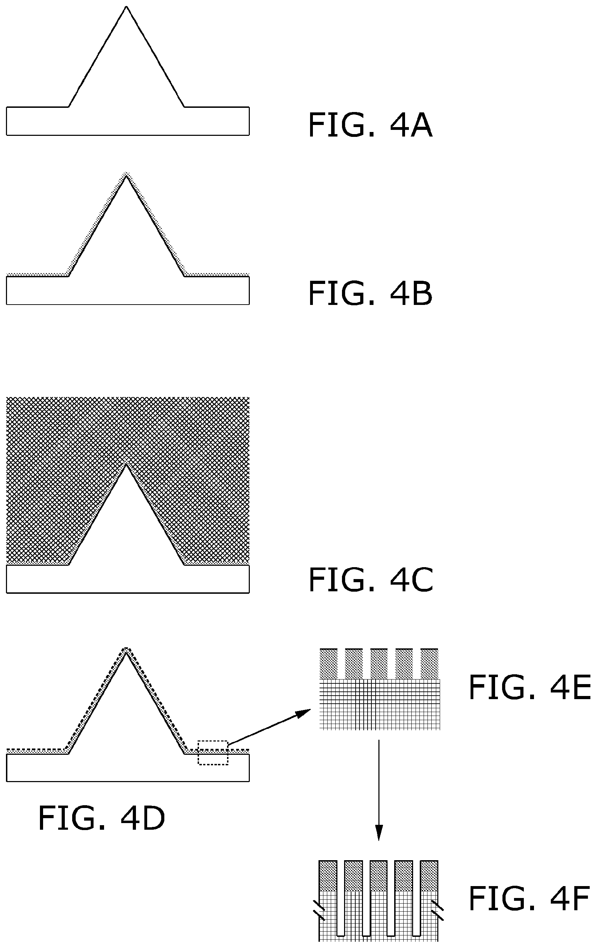

The following mentioned Figure 4A-F show a schematic representation of the steps of the method for manufacturing an emitter for electrospray generator according to a preferred embodiment of the present invention.

Figure 4A shows a substrate (S) before undergoing any step of the method for nanotexturizing at least a protrusion (1.1) of an emitter (1).

Figure 4B shows the first step of the method for nanotexturizing at least a protrusion (1.1) of an emitter (1) where the grey zone represents the first covering layer spread over said at least one protrusion (1.1) following a preferred embodiment of the invention.

Figure 4C shows the second step of the method where the first covering layer (grey zone) is covered by a suspension (area represented by an inclined Cartesian pattern). After covering the surface with the suspension (black zone) comprising particles, the carrier fluid is removed from the suspension (black zone) generating a mask (dashed line) caused by the deposition of the particles, partially protecting the first covering layer, as shown in Figure 4D. According to an embodiment the carrier fluid is removed by a drying process.

Before removing the carrier fluid, according to an embodiment, the particles in suspension (black zone) are electrically charged and the substrate (S) is charged with the opposite charge. The different charge sign between the particle and the substrate (S) causes the particles to move towards the substrate (S) surface and become attached to the substrate (S) forming the mask (dashed line).

Figure 4D shows a third step of the method where the first covering layer (grey zone), protected by a mask of particles (dashed line), undergoes a preliminary etching process that transfers the pattern of the mask of particles (dashed line) to the first covering layer (grey zone). Those parts of the first covering layer that are not protected by particles are attacked in the etching process, opening the first covering layer and exposing the surface of the substrate (S), now partially protected by both the mask of particles and the etched first covering layer, as shown in Figure 4E.

Figure 4E shows a detailed view of the previously cited step of the method where the first covering layer (grey zone) has been etched in the areas not protected by particles of the suspension dashed line).

Figure 4F shows a detailed view of the last step of the method where the substrate undergoes the main etching process and nanowires (1.9) are created, which are formed by a layer of substrate (S) that has not been etched, a layer of first covering layer (grey zone) protected by a particle of the previously spread suspension (black zone) and the remaining particles of the suspension (dashed line). At the end of the process, it is formed a nanowire (1.9) optionally cleaned of all particles and optionally cleaned of the first covering layer (grey zone) which had been previously spread.

As previously explained, and as shown in Figure 1, a region (R) of the emitter (1) has been nanotexturized (1.5) following a first step of the method of the present invention which is covering the surface of the emitter (1.1) to be nanotexturized with a suspension comprising a carrier fluid and particles as shown in Figure 4C.

Then, as shown in Figure 4D, said carrier fluid of the suspension (black zone) is being removed consequently generates a mask (dashed line) of particles attached to the surface of the substrate (S) over the region (R) of the emitter (1) to be nanotexturized. The mask (dashed line) partially protects the region (R) of the emitter (1) to be nanotexturized.

In a preferred embodiment, the suspension (black zone) covering the surface to be nanotexturized, shown in Figure 4C, is a colloidal suspension that comprises colloidal particles which tend to be homogeneously distributed in the suspension (black zone) resulting in a homogeneous distribution when they are deposited on the surface of the substrate (S).

Furthermore, said particles are either nano or micro particles. In a particular embodiment, the colloidal suspension (black zone) comprises polymer particles. In a more particular embodiment, these colloidal suspension comprises one of the following polymer particles: latex, polymethylmethacrylate (PMMA). According to other embodiments particles are made of Si, $SiO2$, ZnO, Zn, FexOy, Al2O3, Au, Pt. Furthermore, the suspension (black zone) preferably comprises a polar solvent.

Finally, a main etching process is performed, as shown in Figure 4F, in order to remove a predetermined depth of substrate (S) of the emitter (1) of its surface that remained unprotected by the previously generated mask (dashed line).

Preferably, the main etching step of the first covering layer spread on the emitter (1) is performed with a combination of fluorinated gases such as $SF_6$, $C_4F_8$ or a combination of those both gases. Also, the main etching step of the substrate (S) of the emitter (1) is an anisotropic etching process.

Moreover, additionally, between the first and the second step of the abovementioned method of the invention, the surface to be nanotexturized can be covered with a first covering layer (grey zone), as shown in Figure 4B.

Then, also additionally and after removing the carrier fluid of the main second step of the method, a preliminary etching process can be performed in order to remove parts of the first covering layer (grey zone), previously spread on the region (R) to be nanotexturized, which consequently transfers the suspension mask (dashed line) to the first covering layer (grey zone) as shown in Figure 4E. Said preliminary etching step is based on the projection of plasma, preferably plasma of Ar, in a direction perpendicular to the plate (1.3).

Also shown in Figure 4E, this preliminary etching is intended for removing the first covering layer (grey zone) unprotected by the mask (dashed line) made of particles of the suspension (black zone) of particles. The mask (dashed line) of particles is transferred to the covering layer (grey zone) which is now the new mask for the main etching to be performed. The preliminary etching process is therefore intended for etching the covering layer (grey zone) but not for etching the substrate (S).

In a preferred embodiment, the first covering layer (grey zone) is a material among the following: Au, Al, Cr, Ti, Ni, Pt, Co, Fe, W, Ta, Cu, Zn, any of the possible alloys among them, $SiO_x$, $Si_xN_y$, $Al_2O_3$, any metal oxide or any combination of them.

In the same preferred embodiment, particles are charged in order to attach and distribute said particles on the first covering layer (grey zone). The first covering layer, the substrate (S) of the emitter (1), or both, has/have an opposite charge causing the particles to migrate to the surface. If the charges of the first covering layer (grey zone), the charges of the substrate (S) of the emitter (1), or both, which are naturally generated due to the material discontinuity, is/are not enough, according to another embodiment, the substrate (S) of the emitter (1), the first covering layer (grey zone), or both, is/are set to an electrical voltage with an electrical charge opposite to the electrical charge of the particles providing a high control on the process.

Consequently, and in a more preferred embodiment, the particles are homogeneously distributed on the first covering layer (grey zone).

Particles located near the surface are attached to the surface and those particles that are farther away from the surface require a migration time that depends on the distance to the surface.

Therefore, the surface charge, the potential applied to the substrate (S) and the waiting time are variables that allow controlling the particle density per unit area.

In a more detailed view of a nanowire (1.9), said nanowire (1.9) is at least a superposition of a remaining particle from the suspension (black zone) previously spread during the first step of the method and part of the substrate (S) that has not been etched by the main etching process.

In the preferred embodiment of the method comprising an additional step of covering the substrate (S) with a first covering layer (grey zone) and as shown in Figure 4F, a nanowire (1.9) is a superposition of a remaining particle from the suspension (black zone) previously spread during the first step of the method, a layer of the first covering layer (grey zone)

which has not been etched by the preliminary etching process and a layer of substrate (S) which has been protected by both the first covering layer (grey zone) and the mask (dashed line), being the new mask generated during the first steps of the method, according to the present invention.

Additionally, and in the same preferred embodiment of the method comprising an additional step of covering the substrate (S) with a covering layer (grey zone), the main etching process is therefore intended for etching both the rest of the covering layer (grey zone), which has not been etched by the preliminary etching, and also for etching part of the substrate (S) of the emitter (1) which has not been covered by the new mask in order to create nanowires (1.9).

According to the present invention, and back to Figure 1, a region (R) of the substrate (S) of the protrusion (1.1) is nanotexturized (1.5) and, after following the main and additional steps of the method, results in forming a plurality of nanowires (not represented in this figure) on said region (R). In a preferred embodiment, as shown in Figure 1, the first side (1.3.1) of the plate (1.3) and external surface of the protrusion (1.1) of the emitter (1) is completely nanotexturized (1.5) thus the nanotexturized region (R) is covering the whole external surface of the emitter (1).

In a preferred embodiment, the nanowires, resulting from the previously detailed method, cover the whole protrusion (1.1) and plate (1.3) of the electrospray generator (10) homogeneously. Also, the nanowires emerge from the low relief etched surface of the emitter (1) with an orientation which is perpendicular to the plate (1.3). In the case of the nanowires being perpendicular to the plate (1.3), the nanowires located on the protrusion are also perpendicular to the plate (1.3) of the emitter (1) resulting the whole set of nanowires in the vertical direction according to the orientation of figure 1.

The emitter (1) shown in Figure 1 produces, in its operative condition, a particle beam (B) having a cone shape and being emitted from the tip (1.4) of the protrusion (1.1) of the electrospray (1)

Also in operative condition, and as shown in Figure 1, once the electrospray generator (1) is emitting a particle beam (B), an emission of particles emanates from the tip (1.4) of the protrusion (1.1) and a cone is observed at the tip of said emitter (1.1).

The electrospray generator (10) also presents, as depicted in Figure 1, an electrode (1.6) which is facing the first side of the plate (1.3.1) of the plate (1.3) of the emitter (1). Said electrode (1.6) is placed distant from the protrusion (1.1) and presents an opening in order to let the generated particle beam (B) pass through.

Additionally, the electrospray generator (10) shows an electrical power supply (1.7) between the substrate (S) of the emitter (1) and the electrode (1.6). The electrical power supply (1.7) set a potential difference between the electrode (1.6) and the semiconductor substrate (S) in such a way that the electric field generated between both elements (1.6, S) is concentrated at the tip (1.4) of the protrusion reaching an intensity that releases ionized particles form the fluid at the tip (1.4).

The continuous flow of ions emitted from the tip (1.4) of the protrusion (1.1) is ensured when the fluid or liquid (1.8.1) flow from the liquid source (1.8) is also sufficient. This implies that the capillary forces of the nanotexturized surface (1.5) favor wetting of the surface and, furthermore, that the hydraulic resistance of the textured surface is not very high favoring sufficient fluid or fluid (1.8) flow but still high enough to achieve the ionic regime.

The specific nanowire structure in which each of the nanowires (not shown in this figure) maintains the same orientation, perpendicular to base (1.2), even over the protrusion (1.1) is what allows a constant and stable liquid (1.8.1) flow even at lower feed potentials. It is this constant liquid (1.8.1) flow that replenishes the liquid in the protrusions, ensuring a continuous and stable ionic regime.

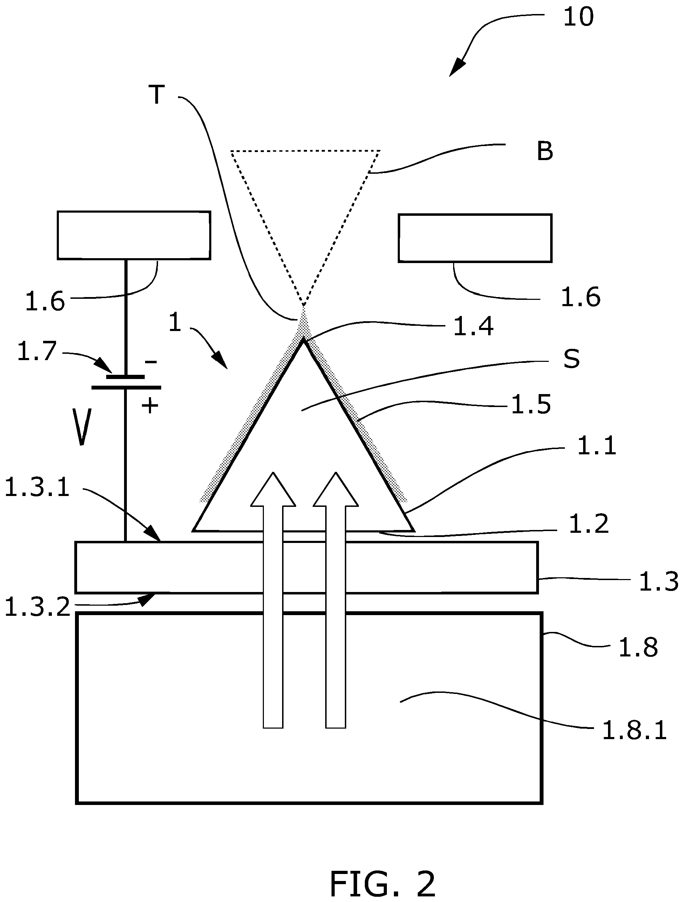

Then, Figure 2 depicts another embodiment of an emitter (1) of an electrospray generator (10) showing a reservoir comprising the liquid (1.8.1) used as ionic liquid propellant. The liquid source (1.8) is fluidically communicated with the nanotexturized surface (1.5) of the plate (1.3) and/or the protrusion (1.1) of the emitter (1) in order to feed said liquid (1.8.1) of the liquid source (1.8) to the surface.

In this particular embodiment, shown in Figure 2, the plate (1.3) is perforated on both of its sides, the first side (1.3.1) and the opposite side (1.3.2) in order to make the connection between the protrusion (1.1) of the emitter (1) and the liquid (1.8.1) from the liquid source (1.8).

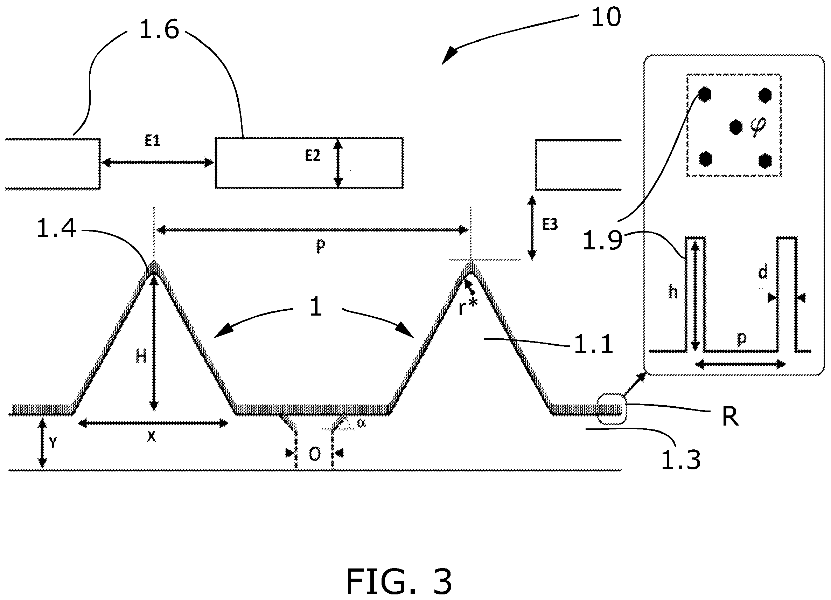

Figure 3 shows a schematic representation of the structure of a plurality of protrusions in an emitter (1) of an electrospray generator (10). In this particular embodiment, each protrusion (1.1) of the emitter (1), having a cone shape, presents a base (1.2) which is defined by its cone diameter $X$. Also, each protrusion (1.1) of the emitter (1) is defined by its height $H$, its tip (1.4) radius $r^*$ and the thickness $Y$ of the plate (1.3) of the emitter (1).

In this particular embodiment, and as depicted in Figure 3, a plurality of protrusions (1.1) are arranged on the plate (1.3), the tip (1.4) of each protrusion (1.1) being separated of a pitch $P$. Moreover, the plate (1.3) of the emitter (1) presents a propellant channel diameter $O$ in order to let the liquid (not shown in this Figure) to pass through the plate (1.3).

The electrospray generator (10) also shows a plurality of portions of the electrode (1.6) represented according to a sectional view, portion of the electrode (1.6) is separated from another portion of the electrode (1.6) by a distance $E1$ and presents a thickness E2. The gap or clearance between two portions of the electrode (1.6) according to the sectional view is the diameter of a perforation in an electrode (1.6) having the form of the grid made of a plate comprising holes. The distance $E1$ existing between two portions of the electrode (1.6) provides enough space for the particle beam (not shown in this Figure) to emerge from each protrusion (1.1). Moreover, each tip (1.4) of each protrusion (1.1) is separated by a distance $E3$ from the electrode (1.6).

On the right side of Figure 3, a more detailed focus is made of the nanotexturized region (R) presenting a plurality of nanowires (1.9). Each nanowire presents structural dimensions such as its height $h$, its diameter $d$ and the distance $p$ in between each nanowire (1.9). Preferably, the dimensions abovementioned provides to a person skilled in the art, the ability to calculate the density of wires $N$ and therefore the volume fraction $\psi$ of wires of the nanotexturized surface. Over the sectional view of two nanowires (1.9), the same detailed focus shows five nanowires (1.9) in a plan view.

All structural dimensions of the plurality of emitters (1) and electrospray generator (10) elements previously mentioned are of the nano or micrometer order.

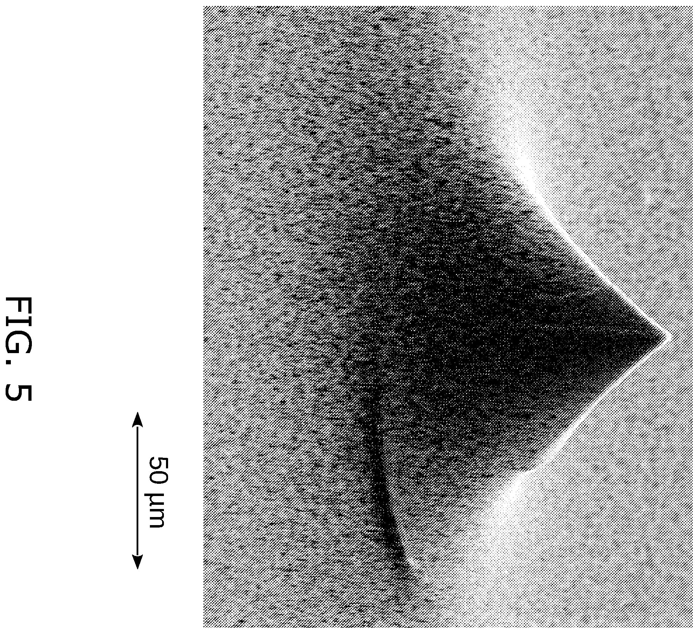

Figure 5, 6 and 7 are images taken by a scanning electron microscope which provides the ability to depict devices such as the present emitter (1) of an electrospray (10) in a macro/nanometer order.

Figure 5 shows a global view of a protrusion (1.1) and a region (R) of an emitter (1) covered by a plurality of nanowires (1.9).

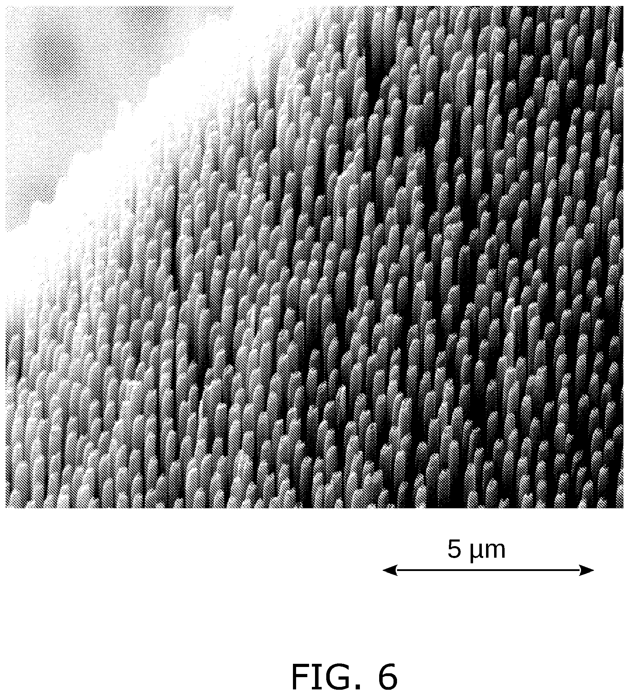

Figure 6 shows a more detailed view of a part of the surface of the protrusion (1.1) of an emitter (1) covered by nanowires (1.9). As seen, the nanowires (1.9) are perpendicular to the plate (1.3) of the emitter (1).

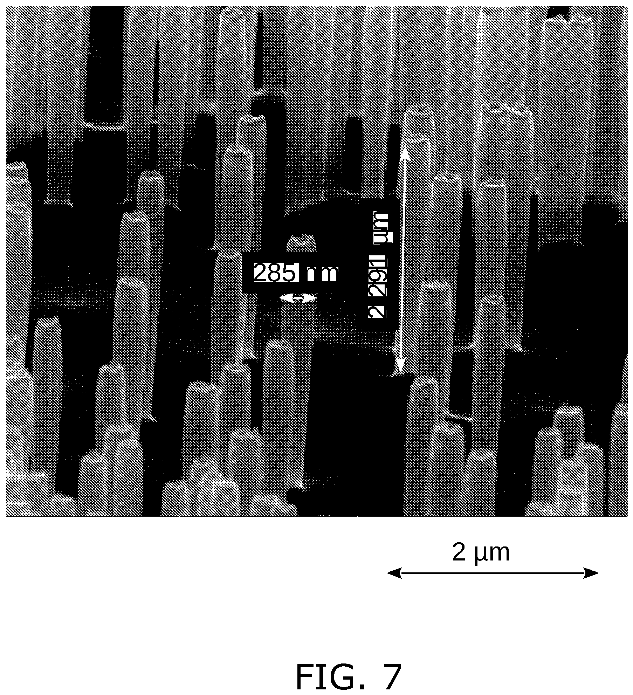

Figure 7 shows an even more detailed view of a part of the surface of the protrusion (1.1) of an emitter (1) covered by nanowires (1.9). In this particular embodiment, the image taken by a scanning electron microscope provides the ability to measure the height $h$ (2.298 $\mu m$) and the diameter $d$ (285 nm) of a nanowire (1.9). This enlarged view also shows the remaining disc of the mask generated during the manufacturing process on the top of each nanowire.

Nanowire coatings add hydraulic resistance to a fluid flowing over the coated surface. The design parameters of the coating, mainly the density of nanowires $N$ and their diameter $d$ determine the permeability $K$ of the coating. The height $h$ of the nanowires (1.9) which defines the height of the coating together with the geometry of the coated surface determine the hydraulic impedance. The hydraulic impedance regulates the total volumetric flow $Q$ which is forced by the pressure difference $\Delta p$ produced due to the electric forces near the liquid (1.8.1) meniscus at the tip of the protrusion (1.1).

It has been proven that the specific nanowires (1.9) structure wherein all the nanowires (1.9) are oriented in the same direction, preferably perpendicular to the plate, the homogeneous distribution and also the low relief maintained at the tip (1.4) of the protrusion (1.1) is the main reason why the emitter (1) supports a higher flow rate under ionic emission conditions than any emitter (1) in the state of the art. The generation of a meniscus under optimal conditions is the driving mechanism of the liquid (1.8.1) flow through the nanowire (1.9) forest. Nonetheless, this same structure on the rest of the nanotexturized surface (1.5) allows the flow feeding the tip (1.4)) to be sufficient to feed the flow demand at the tip (1.4)) to generate the ionic flow.

The embodiments that has been experimented has been realized with the following dimension parameters for the nanowire coating:

| Parameter | Lower | Nominal | Upper | Unit |
|---|---|---|---|---|
| $N$ | 0.01 | 0.12 | 2 | $\mu m^{-2}$ |
| $d$ | 100 | 300 | 500 | $nm$ |
| $h$ | 1 | 2 | 10 | $\mu m$ |
| $H$ | 100 | 300 | 1000 | $\mu m$ |
| $K$ | $10^{-16}$ | $1.1 \cdot 10^{-12}$ | $10^{-11}$ | $m^2$ |
| $R_H$ | $10^{15}$ | $5 \cdot 10^{16}$ | $10^{20}$ | $Pa.s.m^{-3}$ |

The ionic liquid used for realizing experiments, such as EMI-BF$_4$, presents the following properties:

$$\gamma = 0.045 N \cdot m^{-1}$$

$$\kappa = 13.8$$

$$\rho = 1280 kg \cdot m^{-3}$$

$$k = 1.2 S \cdot m^{-1}$$

$$\mu = 0.040 Pa \cdot s$$

**Claims**

1. Method for manufacturing an emitter (1) for electrospray generators (10), the method comprising the steps:

   - providing a substrate (S), the substrate (S) comprising:

     a plate (1.3);
     at least one protrusion (1.1) with a base (1.2) located on a first side (1.3.1) of the plate (1.3); the at least one protrusion (1.1) ended in a tip (1.4);

   - nanotexturizing the outer surface of the at least one protrusion (1.1),

   **characterized in that**, nanotexturizing the outer surface process comprises the steps:

     a) covering the surface with a suspension comprising a carrier fluid and particles;
     b) removing the carrier fluid from the suspension leaving behind a mask comprising a plurality of the particles partially protecting the surface;
     c) carrying out, in a direction perpendicular to the plate (1.3), a main etching process for removing a predetermined depth of the substrate not being protected by the particles, wherein the main etching process is configured for showing a low-relief etched surface with nanowires emerging from the low-relief surface in a direction perpendicular to the plate (1.3) even in those nanowires (1.9) located on the protrusion (1.1).

2. Method according to claim 1, wherein at least one region (R) connected with the at least one protrusion (1.1) of the first side (1.3.1) of the plate (1.3) is nanotexturized.

3. Method according to any of the previous claims, wherein the suspension is a colloidal suspension comprising colloidal particles.

4. Method according to any of the previous claims, wherein nanotexturizing the outer surface process further comprises:

   - before step a), covering the surface to be nanotexturized with a first covering layer; and,
   - after step b) and before step c), carrying out a preliminary etching process, respectively to the main etching process from step c), for removing the parts of the first covering layer not being protected by the mask of particles, resulting in a transference of the suspension mask to the first covering layer.

5. A method according to any of the previous claims, wherein the suspension composition comprises charged particles in order to ease the attachment and distribution of the particles on the first covering layer.

6. A method according to claim 5, wherein the first covering layer, the substrate or both has/have a surface charge by means of:

   - a pre-surface chemical or plasma treatment;
   - providing an electrical voltage;
   - or both.

7. A method according to any of the previous claims, wherein the main etching step is an anisotropic etching process of the substrate (S).

8. A method according to any of the previous claims, wherein the substrate (S) is a semiconductor, wherein specifically the substrate (S) is Si.

9. A method according to any the claims 1 to 7, wherein the substrate (S) is glass.

10. A method according to any of previous claims, wherein the tip (1.4) is a structure adapted for electric field concentration.

11. An emitter (1) for electrospray generators (10), the emitter (1) being a substrate (S) and the substrate (S) comprising:

   - a plate (1.3);
   - at least one protrusion (1.1) with a base (1.2) located on a first side (1.3.1) of the plate (1.3); the at least one protrusion (1.1) ended in a tip (1.4);
   wherein the outer surface of the at least one protrusion (1.1) is nanotexturized according to any of the preceding claims; and,
   wherein the nanotexturized surface (1.5) shows a low-relief etched surface with nanowires emerging from the low-relief surface in a direction perpendicular to the plate (1.3) even in those nanowires (1.9) located on the protrusion (1.1).

12. An emitter (1) according to the precedent claim, wherein the substrate (S) comprises at least one liquid source (1.8) and, wherein each protrusion (1.1) has at least one liquid source (1.8) located at the protrusion (1.1) or at a connected region (R) of the substrate (S) adapted to feed the base (1.2) of the protrusion (1.1).

13. An emitter (1) according to claim 12, wherein the connected region (R) of the substrate (S) is further nanotexturized.

14. An emitter (1) according to any of claims 11 to 13, wherein the hydraulic resistance $R_H$ is ranging in $10^{15}$-$10^{20}Pa.s.m^{-3}$, more preferably in $10^{15}$-$10^{18}Pa.s.m^{-3}$, even more preferably in $10^{16}$-$10^{18} Pa.s.m^{-3}$, $R_H$ being calculated as:

$$R_H = \frac{-\mu ln(r^*/H)}{2\pi Khsin\alpha}$$

wherein the permeability, $K$, is calculated as:

$$\frac{K}{d^2} = 0.16 \frac{\left[\frac{\pi}{2\sqrt{3}\psi} - 3\sqrt{\frac{\pi}{2\sqrt{3}\psi}} + 3 - \sqrt{\frac{2\sqrt{3}\psi}{\pi}}\right]}{\sqrt{1-\psi}}$$

and wherein the volume fraction $\psi$ is calculated as:

$$\psi = N \cdot \frac{\pi d^2}{4}$$

wherein $H$ is the hight of the protrusion (1.1), $h$ is the height of the nanotexturized surface (1.5), $r^*$ is the radius of the tip (1.4) of the protrusion (1.1), $\alpha$ the semi-angle of the protrusion (1.1) according to a sectional view, $\mu$ is the dynamic viscosity, $d$ the diameter of the wires (1.9) of the nanotexturized surface (1.5) and $\psi$ is the volume fraction of wires (1.9) of the nanotexturized surface (1.5) and $N$ is the density of wires (1.9).

15. An electrospray generator (10) comprising:

   - an emitter (1) according to any of claims 11 to 14;
   - an electrode (1.6) facing the first side (1.3.1) of the plate (1.3) of the emitter (1) with the at least one protrusion (1.1) and separated from said at least one protrusion (1.1);
   - the electrode (1.6) comprising at least an opening for letting generated ions or drops to pass through;
   - an electrical power supply (1.7) for setting voltage between the substrate (S) and the electrode (1.6);
   - a liquid source (1.8) fluidically communicated with the nanotexturized surface (1.5) of the plate (1.3) for feeding liquid (1.8.1) to said surface (1.5).

**Patentansprüche**

1. Verfahren zum Herstellen eines Emitters (1) für Elektrospray-Generatoren (10), wobei das Verfahren die Schritte aufweist:

   - Bereitstellen eines Substrats (S), wobei das Substrat (S) aufweist:

     eine Platte (1.3);
     mindestens einen Vorsprung (1.1) mit einer auf einer ersten Seite (1.3.1) der Platte (1.3) angeordneten Basis (1.2), wobei der mindestens eine Vorsprung (1.1) in einer Spitze (1.4) endet;

   - Nanostrukturieren der Außenfläche des mindestens einen Vorsprungs (1.1),

   **dadurch gekennzeichnet, dass**
   der Prozess zum Nanostrukturieren der Außenfläche die Schritte aufweist:

   a) Bedecken der Oberfläche mit einer Suspension, die ein Trägerfluid und Partikel enthält;
   b) Entfernen des Trägerfluids aus der Suspension, wobei eine Maske zurückbleibt, die eine Vielzahl der Partikel aufweist, die die Oberfläche teilweise schützen;
   c) Ausführen eines Hauptätzprozesses in einer Richtung senkrecht zur Platte (1.3) zum Entfernen einer vorgegebenen Tiefe des Substrats das nicht durch die Partikel geschützt ist, wobei der Hauptätzprozess derart konfiguriert ist, dass eine flachreliefartig geätzte Oberfläche mit Nanodrähten erhalten wird, die von der flachreliefartigen Oberfläche in einer Richtung senkrecht zur Platte (1.3) hervorstehen, auch in den Nanodrähten (1.9), die sich auf dem Vorsprung (1.1) befinden.

2. Verfahren nach Anspruch 1, wobei mindestens ein Bereich (R), der mit dem mindestens einen Vorsprung (1.1) der ersten Seite (1.3.1) der Platte (1.3) verbunden ist, nanostrukturiert wird.

3. Verfahren nach einem der vorangehenden Ansprüche, wobei die Suspension eine kolloidale Suspension ist, die kolloidale Partikel enthält.

4. Verfahren nach einem der vorangehenden Ansprüche, wobei der Prozess zum Nanostrukturieren der Außenfläche ferner aufweist:

   - vor Schritt a): Bedecken der einer Nanostrukturierung zu unterziehenden Oberfläche mit einer ersten Deckschicht; und
   - nach Schritt b) und vor Schritt c) Ausführen eines Vorätzprozesses in Bezug auf den Hauptätzprozess von Schritt c) zum Entfernen der Teile der ersten Deckschicht, die nicht durch die Maske aus Partikeln geschützt sind, wodurch die Suspensionsmaske auf die erste Deckschicht übertragen wird.

5. Verfahren nach einem der vorangehenden Ansprüche, wobei die Suspensionszusammensetzung geladene Partikel enthält, um ein Anhaften und Verteilen der Partikel auf der ersten Deckschicht zu erleichtern.

6. Verfahren nach Anspruch 5, wobei die erste Deckschicht und/oder das Substrat eine Oberflächenladung aufweist/aufweisen durch:

   - eine chemische Vorbehandlung oder Plasmabehandlung der Oberfläche;
   - Anlegen einer elektrischen Spannung;
   - oder beides.

7. Verfahren nach einem der vorangehenden Ansprüche, wobei der Hauptätzschritt ein anisotroper Ätzprozess des Substrats (S) ist.

8. Verfahren nach einem der vorangehenden Ansprüche, wobei das Substrat (S) ein Halbleiter ist, wobei insbesondere das Substrat (S) Si ist.

9. Verfahren nach einem der Ansprüche 1 bis 7, wobei das Substrat (S) Glas ist.

10. Verfahren nach einem der vorangehenden Ansprüche, wobei die Spitze (1.4) eine Struktur ist, die zum Konzentrieren eines elektrischen Feldes geeignet ist.

11. Emitter (1) für Elektrospray-Generatoren (10), wobei der Emitter (1) ein Substrat (S) ist und das Substrat (S) aufweist:

- eine Platte (1.3);
- mindestens einen Vorsprung (1.1) mit einer auf einer ersten Seite (1.3.1) der Platte (1.3) angeordneten Basis (1.2), wobei der mindestens eine Vorsprung (1.1) in einer Spitze (1.4) endet,
wobei die Außenfläche des mindestens einen Vorsprungs (1.1) gemäß einem der vorangehenden Ansprüche nanostrukturiert ist, und
wobei die nanostrukturierte Oberfläche (1.5) eine flachreliefartig geätzte Oberfläche aufweist, wobei von der flachreliefartig geätzten Oberfläche Nanodrähte in einer Richtung senkrecht zur Platte (1.3) hervorstehen, auch in den Nanodrähten (1.9), die sich auf dem Vorsprung (1.1) befinden.

12. Emitter (1) nach dem vorangehenden Anspruch, wobei das Substrat (S) mindestens eine Flüssigkeitsquelle (1.8) aufweist, und wobei jeder Vorsprung (1.1) mindestens eine Flüssigkeitsquelle (1.8) aufweist, die an dem Vorsprung (1.1) oder an einem verbundenen Bereich (R) des Substrats (S) angeordnet ist, der dazu ausgelegt ist, die Basis (1.2) des Vorsprungs (1.1) zu versorgen.

13. Emitter (1) nach Anspruch 12, wobei der verbundene Bereich (R) des Substrats (S) ebenfalls nanostrukturiert ist.

14. Emitter (1) nach einem der Ansprüche 11 bis 13, wobei der hydraulische Widerstand $R_H$ im Bereich von $10^{15}$ - $10^{20}$ Pa·s·m$^{-3}$ liegt, vorzugsweise im Bereich von $10^{15}$ - $10^{18}$ Pa·s·m$^{-3}$, noch bevorzugter im Bereich von $10^{16}$ - $10^{18}$ Pa.s.m$^{-3}$, wobei $R_H$ berechnet wird als:

$$R_H = -\frac{\mu \, ln(r^*/H)}{2\pi K h \, sin \, \alpha}$$

wobei die Permeabilität K berechnet wird als:

$$\frac{K}{d^2} = 0.16 \frac{\left[ \sqrt{\frac{\pi}{2\sqrt{3}\psi}} - 3\sqrt{\frac{\pi}{2\sqrt{3}\psi}} + 3 - \sqrt{\frac{2\sqrt{3}\psi}{\pi}} \right]}{\sqrt{1-\psi}}$$

und wobei der Volumenanteil $\psi$ berechnet wird als:

$$\psi = N \cdot \frac{\pi d^2}{4} \, ,$$

wobei H die Höhe der Vorsprünge (1.1) ist, h die Höhe der nanostrukturierten Oberfläche (1.5) ist, r* der Radius der Spitze (1.4) der Vorsprünge (1.1) ist, $\alpha$ der Halbwinkel des Vorsprungs (1.1) in einer Schnittansicht betrachtet ist, $\mu$ die dynamische Viskosität ist, d der Durchmesser der Drähte (1.9) der nanostrukturierten Oberfläche (1.5) ist, $\psi$ der Volumenanteil der Drähte (1.9) der nanostrukturierten Oberfläche (1.5) ist und N die Dichte der Drähte (1.9) ist.

15. Elektrospray-Generator (10), mit:

- einem Emitter (1) nach einem der Ansprüche 11 bis 14;
- einer Elektrode (1.6), die der ersten Seite (1.3.1) der Platte (1.3) des Emitters (1) mit dem mindestens einen Vorsprung (1.1) zugewandt und von dem mindestens einen Vorsprung (1.1) getrennt ist,
- wobei die Elektrode (1.6) mindestens eine Öffnung zum Durchlassen von erzeugten Ionen oder Tropfen aufweist;
- einer elektrischen Stromversorgung (1.7) zum Anlegen einer Spannung zwischen dem Substrat (S) und der Elektrode (1.6); und
- einer Flüssigkeitsquelle (1.8), die mit der nanostrukturierten Oberfläche (1.5) der Platte (1.3) in Fluidkommunikation steht, um dieser Oberfläche (1.5) Flüssigkeit (1.8.1) zuzuführen.

## Revendications

1. Procédé de fabrication d'un émetteur (1) pour des générateurs d'électrospray (10), comprenant les étapes suivantes :

   - fournir un substrat (S), le substrat (S) comprenant :

     une plaque (1.3) ;
     au moins une protubérance (1.1) avec une base (1.2) située sur un premier côté (1.3.1) de la plaque (1.3) ;
     l'au moins une protubérance (1.1) se terminant par une pointe (1.4) ;

   - nanotexturer la surface extérieure de l'au moins une protubérance (1.1),

   **caractérisé en ce que** le processus de nanotexturation de la surface extérieure comprend les étapes suivantes :

   a. recouvrir la surface d'une suspension comprenant un fluide porteur et des particules ;
   b. retirer le fluide porteur de la suspension en laissant un masque comprenant une pluralité des particules protégeant partiellement la surface ;
   c. effectuer, dans une direction perpendiculaire à la plaque (1.3), un processus de gravure principal d'enlèvement d'une profondeur prédéterminée du substrat non protégé par les particules, dans lequel le processus de gravure principal est configuré pour montrer une surface gravée à faible relief avec des nanofils émergeant de la surface à faible relief dans une direction perpendiculaire à la plaque (1.3), même dans ces nanofils (1.9) situés sur la protubérance (1.1).

2. Procédé selon la revendication 1, dans lequel au moins une région (R) reliée à l'au moins une protubérance (1.1) du premier côté (1.3.1) de la plaque (1.3) est nanotexturée.

3. Procédé selon l'une quelconque des revendications précédentes, dans lequel la suspension est une suspension colloïdale comprenant des particules colloïdales.

4. Procédé selon l'une quelconque des revendications précédentes, dans lequel le processus de nanotexturation de la surface extérieure comprend en outre :

   - avant l'étape a), recouvrir la surface à nanotexturiser d'un premier revêtement et,
   - après l'étape b) et avant l'étape c), exécuter un processus de gravure préliminaire, respectivement au processus de gravure principal de l'étape c), pour enlever les parties de la première couche de revêtement qui ne sont pas protégées par le masque de particules, entraînant un transfert du masque de suspension à la première couche de revêtement.

5. Procédé selon l'une quelconque des revendications précédentes, dans lequel la composition de la suspension comprend des particules chargées afin de faciliter la fixation et la distribution des particules sur la première couche de revêtement.

6. Procédé selon la revendication 5, dans lequel la première couche de revêtement, le substrat ou les deux a/ont une charge de surface au moyen de :

   - un traitement chimique ou plasma préalable à la surface ;
   - l'application d'une tension électrique ;
   - ou les deux.

7. Procédé selon l'une quelconque des revendications précédentes, dans lequel l'étape principale de gravure est un processus de gravure anisotrope du substrat (S).

8. Procédé selon l'une quelconque des revendications précédentes, dans lequel le substrat (S) est un semi-conducteur, en particulier le substrat (S) est du Si.

9. Procédé selon l'une quelconque des revendications 1 à 7, dans lequel le substrat (S) est du verre.

10. Procédé selon l'une quelconque des revendications précédentes, dans lequel la pointe (1.4) est une structure adaptée à la concentration du champ électrique.

11. Émetteur (1) pour générateurs d'électrospray (10), l'émetteur (1) étant un substrat (S) et le substrat (S) comprenant :

    - une plaque (1.3) ;
    - au moins une protubérance (1.1) avec une base (1.2) située sur un premier côté (1.3.1) de la plaque (1.3) ; l'au moins une protubérance (1.1) se terminant par une pointe (1.4) ;
    dans lequel la surface extérieure de l'au moins une protubérance (1.1) est nanotexturée selon l'une quelconque des revendications précédentes ; et,
    dans lequel la surface nanotexturée (1.5) présente une surface gravée à faible relief avec des nanofils émergeant de la surface à faible relief dans une direction perpendiculaire à la plaque (1.3) même dans ces nanofils (1.9) situés sur la protubérance (1.1).

12. Emetteur (1) selon la revendication précédente, dans lequel le substrat (S) comprend au moins une source de liquide (1.8) et, dans lequel chaque protubérance (1.1) a au moins une source de liquide (1.8) située au niveau de la protubérance (1.1) ou d'une région connectée (R) du substrat (S) adaptée pour alimenter la base (1.2) de la protubérance (1.1).

13. Emetteur (1) selon la revendication 12, dans lequel la zone connectée (R) du substrat (S) est en outre nanotexturé.

14. Emetteur (1) selon l'une quelconque des revendications 11 à 13, dans lequel la résistance hydraulique $R_H$ est comprise entre $10^{15}$ et $10^{20}$ Pa.s.m$^{-3}$, de préférence entre $10^{15}$ et $10^{18}$ Pa.s.m$^{-3}$, de préférence encore entre $10^{16}$ et $10^{18}$ Pa.s.m$^{-3}$, $R_H$ étant calculé comme suit :

$$R_H = \frac{-\mu ln(r^*/H)}{2\pi K h sin\alpha}$$

où la perméabilité, K, est calculée comme suit :

$$\frac{K}{d^2} = 0.16 \frac{\left[ \frac{\pi}{2\sqrt{3}\psi} - 3\sqrt{\frac{\pi}{2\sqrt{3}\psi}} + 3 - \sqrt{\frac{2\sqrt{3}\psi}{\pi}} \right]}{\sqrt{1-\psi}}$$

et dans lequel la fraction $\psi$ de volume est calculée comme suit :

$$\psi = N \cdot \frac{\pi d^2}{4}$$

où H est la hauteur de la protubérance (1.1), h est la hauteur de la surface nanotexturée (1.5), $r^*$ est le rayon de la pointe (1.4) de la protubérance (1.1), $\alpha$ le demi-angle de la protubérance (1.1) selon une vue en coupe, $\mu$ est la viscosité dynamique, d le diamètre des fils (1.9) de la surface nanotexturée (1.5) et $\psi$ est la fraction volumique des fils (1.9) de la surface nanotexturée (1.5) et N est la densité des fils (1.9).

15. Un générateur d'électrospray (10) comprenant :

    - un émetteur (1) selon l'une quelconque des revendications 11 à 14 ;
    - une électrode (1.6) faisant face au premier côté (1.3.1) de la plaque (1.3) de l'émetteur (1) avec l'au moins une protubérance (1.1) et séparée de ladite au moins une protubérance (1.1) ;

- l'électrode (1.6) comprenant au moins une ouverture pour laisser passer à travers les ions ou les gouttes générés ;
- une alimentation électrique (1.7) pour régler la tension entre le substrat (S) et l'électrode (1.6) ;
- une source de liquide (1.8) communicant fluidiquement avec la surface nanotexturée (1.5) de la plaque (1.3) pour alimenter en liquide (1.8.1) ladite surface (1.5).

FIG. 1

FIG. 2

FIG. 3

EP 4 364 177 B1

FIG. 4A

FIG. 4B

FIG. 4C

FIG. 4E

FIG. 4D

FIG. 4F

50 µm

FIG. 5

5 µm

FIG. 6

2 µm

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014193995 A1

**Non-patent literature cited in the description**

- HIGH-THROUGHPUT IONIC LIQUID ION SOURCES USING ARRAYS OF MICROFABRI-CATED ELECTROSPRAY EMITTERS WITH INTE-GRATED EXTRACTOR GRID AND CARBON NA-NOTUBE FLOW CONTROL STRUCTURES. **FRANCES ANN et al.** journal of microelectromechanical systems. IEEE SERVICE CENTER, 16 May 2014, vol. 23